# EUROPEAN PATENT SPECIFICATION

(11) **EP 0 573 241 B1**
(45) Date of publication and mention of the grant of the patent: **09.02.2000**
(21) Application number: 93304216.0
(22) Date of filing: 01.06.1993
(51) Int. Cl.: H01L 21/768, H01L 23/485, H01L 21/3205

(54) **Semiconductor devices with a double layered silicide structure and process of making it**
Halbleitervorrichtungen mit einer doppelschichtigen Silizidstruktur und Verfahren zu ihrer Herstellung
Dispositifs semi-conducteurs comportant une structure à double couche de siliciure et leur procédé de fabrication

(30) Priority: 30.05.1992 KR 941492
(43) Date of publication of application: 08.12.1993
(73) Proprietor: SAMSUNG ELECTRONICS CO., LTD., Suwon-City, Kyungki-do (KR)
(72) Inventor: Paek, Su-Hyon, Kangnam-gu, Seoul (KR); Choi, Jin-Seog, Paldal-gu, Suwon-city, Kyungki-do (KR)
(74) Representative: Stanley, David William

(56) References cited:
- EP-A- 0 295 367
- IBM TECHNICAL DISCLOSURE BULLETIN. vol. 27, no. 7B , December 1984 , NEW YORK US pages 4402 - 4404 K.W.CHOI ET AL. 'IMPROVED SALICIDE PROCESS WITH MULTILAYER SILICIDE FORMATION'
- IBM TECHNICAL DISCLOSURE BULLETIN. vol. 28, no. 9 , February 1986 , NEW YORK US pages 3968 - 3969 'UNDERLAYER FIR POLYCIDE PROCESS'
- RESEARCH DISCLOSURE vol. 323 , March 1991 , HAVANT GB page 208 'IMPROVED TISI2 FILMS FOR VLSI TECHNOLOGY'

## Description

The present invention relates to semiconductor devices.

In semiconductor devices, a refractory metal silicide such as titanium silicide is generally utilized for contriving low resistance of internal wiring materials.

Titanium silicide is obtained by combining titanium (Ti), which is a refractory metal, with silicon (Si), and has excellent electrical conductivity and remarkable heat-resistance. Accordingly, titanium silicide is favourable for microstructure processing, and therefore it is suitable for a highly integrated semiconductor memory device. Titanium silicide is widely applied to self-aligned silicide (SALICIDE) thanks to its low resistance property. (Refer to IEDM 9-12, December, 1990, pp. 249-252.)

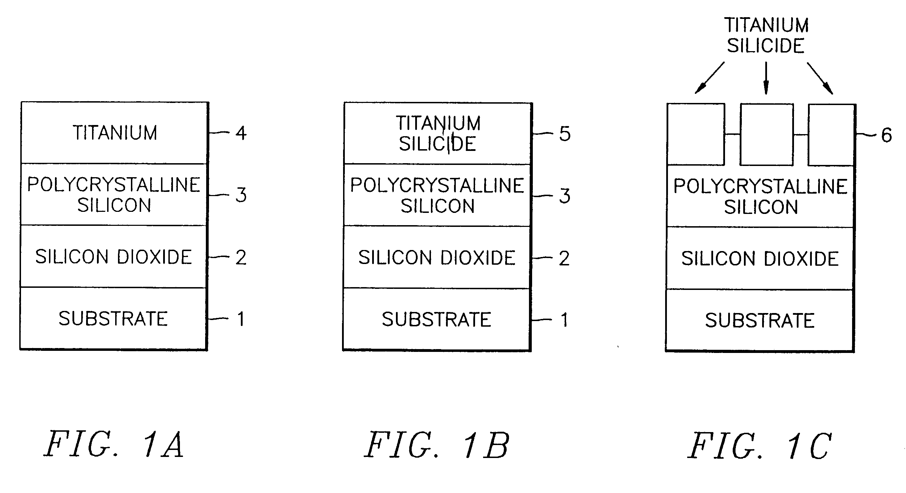

Figures 1A, 1B and 1C of the accompanying diagrammatic drawings illustrate an example of forming titanium silicide according to a conventional technique. In the step shown in Figure 1A, a silicon dioxide (SiO₂) layer 2 is grown to a thickness of about 1,000Å (10 Å = 1 nm) on a monocrystalline silicon substrate 1 whose specific resistance is about 5∼25Ωcm at a temperature of about 920°C, via a thermal oxidation. Then, silane (SiH₄) is thermally decomposed at approximately 625°C under an atmosphere of 250mTorr (1 mTorr = 10⁻³ Torr = 1,33 10⁻¹ Pa) through a low-pressure chemical vapor deposition (LPCVD) to thereby deposit a polycrystalline silicon layer 3 on the upper portion of the silicon dioxide layer 2 to a thickness of about 2,500Å. After depositing the polycrystalline silicon layer 3, phosphorous (P) is implanted into the polycrystalline silicon layer 3 via an ion-implantation method. At this time, the ion implantation energy is roughly 30KeV, and a dose quantity is roughly 5 × 10¹⁵ions/cm². In order to prevent damage on the surface of the polycrystalline silicon layer 3 caused by the ion implantation, furnace annealing is carried out at about 900°C for 30 minutes. Upon completing the furnace annealing, titanium is deposited on the upper portion of the polycrystalline silicon 3 to a thickness of about 400∼600Å via a sputtering method, and the resultant structure is subjected to rapid furnace annealing at about 800°C under an argon (Ar) atmosphere for approximately 20 seconds. This rapid furnace annealing permits the polycrystalline silicon 3 and the titanium 4 to react with each other, thereby forming the titanium silicide 5 as shown in Figure 1B.

The melting point of titanium silicide is approximately 1540°C, i.e. 1813°K in units of absolute temperature, and its high-temperature unstability begins occurring at 814°C, which is 0.6 times the absolute temperature. It is well known to one ordinary skilled in the art that the refractory metal silicide begins to be unstable at a given temperature which is obtained by multiplying the absolute temperature of its melting point by 0.6. The melting point of titanium silicide may vary slightly varied according to processing circumstances, and generally the high-temperature unstability begins occurring at 900°C.

Therefore, during a subsequent furnace annealing at a high-temperature of 900°C or higher, grain growth and plastic deformation are developed in titanium silicide. At the same time, agglomeration phenomenon is produced in a homogeneous thin film due to the epitaxial growth of silicon, which induces a discontinuous thin film having a microstructure as islands.

In other words, as shown in a structure 6 of Figure 1C, the titanium silicide has a discontinuous thin film in a shape of islands, so that the surface of the polycrystalline silicon 3 is exposed. Due to the discontinuous structure of the titanium silicide, a internal wiring resistance becomes significantly increased. As described above, the increase of the wiring resistance adversely affects operational characteristics of a semiconductor memory device, and degrades reliability of the operation.

IBM Technical Disclosure Bulletin Volume 28 No.9 February 1986 page 3968 "Underlayer for Polycide Process" describes the provision of an intermediary titanium layer of 10-50 naometres deposited on a polysilicon layer. A tungsten silicide layer is deposited on the titanium layer. The intermediary titanium layer allows for easy nucleation of the tungsten silicide layer and more importantly provides for greater adhesion between the tungsten silicide layer and the polysilicon layer.

Research Disclosure, volume 323, March 1991 Havant GB, page 208 "Improved TiSi₂ films for VLSI technology" describes the addition of 3 at % of aluminium to the initial titanium film to lower its specific surface energy, and hence increase its morphological stability. Addition of aluminium as an alloying agent with sufficient mobility to be able to move to the surface to be effective is described, preserving continuity and low resistance of the film at higher temperatures.

Preferred embodiments of the present invention aim to provide a semiconductor device capable of homogeneously maintaining the surface of titanium silicide during a subsequent furnace annealing at a high temperature, and a method for fabricating the same.

It is another aim to provide a semiconductor device for improving high-temperature instability of titanium silicide caused in the conventional technique, and a method for fabricating the same.

According to claim 1 of the present invention, there is provided a method of fabricating a semiconductor device having a double-layered silicide structure, comprising:
forming an oxide layer on a monocrystalline silicon substrate;
growing a polycrystalline silicon layer on the oxide layer;
forming a first layer of a first metal silicide on the polycrystalline layer and a second layer of a second metal silicide on the first layer, the second metal silicide having a melting point which is lower than that of the first metal silicide, by depositing a first layer of the first metal and a second layer of the second metal and annealing the first and second layers to form respective layers of metal silicide.

The deposited thickness of the first layer of the first metal may be 100∼200Å. The deposited thickness of the second layer of the second metal may be 400∼600Å.

According to claim 4 of the present invention, there is provided a method of fabricating a semiconductor device having a double-layered silicide structure, comprising:
forming an oxide layer on a monocrystalline silicon substrate;
growing a polycrystalline silicon layer on the oxide layer;
depositing a first layer of a first metal silicide on the polycrystalline layer, via a sputtering method using a first composite target;
depositing a second layer of a second metal silicide on the first layer, via a sputtering method using a second composite target, the second metal silicide having a melting point which is lower than that of the first metal silicide.

Preferably, the method comprises annealing the first and second metal silicide layers.

The deposited thickness of the first silicide layer may be 200∼400Å. The deposited thickness of the second silicide layer may be 800∼1,200Å. The polycrystalline silicon layer may be deposited to a thickness of about 2,500Å.

The first metal may be tantalum (Ta), molybdenum (Mo) or tungsten (W). The second metal may be titanium (Ti).

The polycrystalline silicon layer may be deposited by thermally decomposing silane (SiH₄) at a temperature of 625°C under an atmosphere of 250mTorr through low-pressure chemical vapor deposition.

The annealing may take place at a high temperature in the range 800° to 900°C or greater.

Preferably, the oxide layer is formed on an entire surface of said substrate, the polycrystalline layer is formed on a entire surface of said oxide layer and the first and second metal silicide layers are formed one above the other on an upper portion of said polycrystalline layer.

The present inventiom also extends to a semiconductor device according to claim 13 having a double-layered silicide structure, comprising a monocrystalline silicon substrate, an oxide layer formed on the substrate, a polycrystalline silicon layer formed on the oxide layer, a first layer of a first metal silicide formed on the polycrystalline layer and a second layer of a second metal silicide formed on the first layer, the second metal silicide having a melting point which is lower than that of the first metal silicide.

For a better understanding of the invention, and to show how the same may be carried into effect, reference will now be made, by way of example, to Figures 2 to 4 of the accompanying diagrammatic drawings, in which:
Figures 2A and 2B are sectional views showing one embodiment of a fabricating process of a semiconductor device according to the present invention;
Figures 3A and 3B are sectional views showing another embodiment of a fabricating process of a semiconductor device according to the present invention; and
Figure 4 is a table comparing the sheet resistances of semiconductor devices according to a conventional technique and according to embodiments of the present invention.

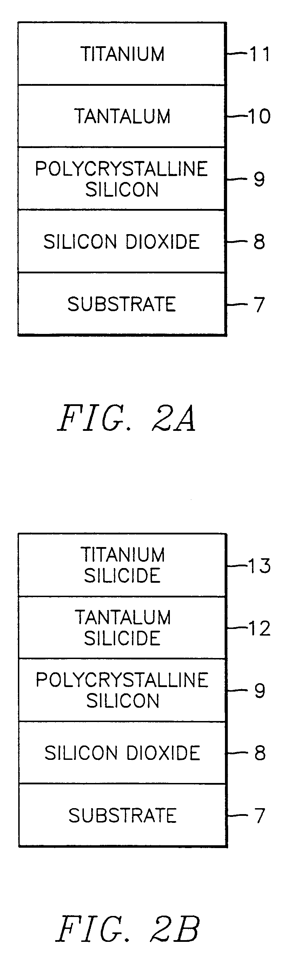

In Figure 2A, a silicon dioxide (SiO₂) layer 8 is grown to a thickness of about 1,000Å on a monocrystalline silicon substrate 7 whose specific resistance is roughly 5 ∼ 25Ωcm at 920°C via a thermal oxidation. After that, silane (SiH₄) is thermally decomposed at a temperature of about 625°C under an atmosphere of 250mTorr via a low-pressure chemical vapor deposition (LPCVD) to thereby deposit a polycrystalline silicon layer 9 to a thickness of about 2,500Å on the upper portion of the silicon dioxide layer 8. Then, phosphorous (P) is implanted into the polycrystalline silicon layer 9 through an ion-implantation method. At this time, ion-implantation energy is approximately 30KeV, and dose quantity is approximately 5 × 10¹⁵ions/cm². In order to prevent damage on the surface of the polycrystalline silicon layer 9 caused by the ion implantation, an etching is performed, using a buffered HF solution obtained by dissolving hydrofluoride (HF) into water in a ratio of 1:100. After performing the etching, tantalum 10 is deposited on the upper portion of the polycrystalline silicon layer 9 to a thickness of about 100 ∼ 200Å via a sputtering method, and then titanium 11 is deposited thereon to a thickness of about 400 ∼ 600Å via a sputtering method. When completing the deposition of the titanium 11, the resultant structure is subjected to rapid furnace annealing at 800°C under an argon (Ar) atmosphere for about 20 seconds. By this rapid furnace annealing, as shown in Figure 2B, the polycrystalline silicon 9 reacts with the tantalum 10 to thereby form tantalum silicide (TaSi₂) 12, and the polycrystalline silicon 9 reacts with the titanium 11 to thereby form a titanium silicide (TiSi₂) 13.

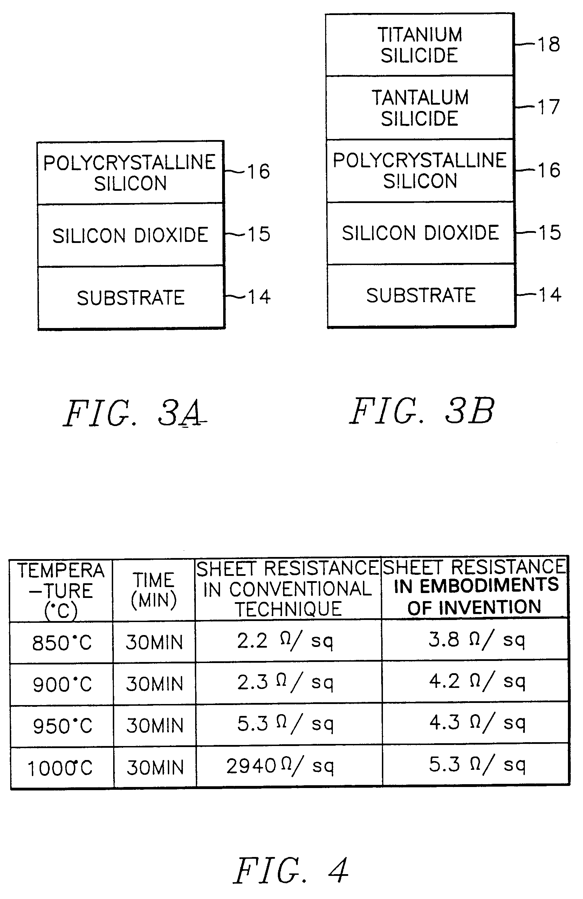

Figures 3A and 3B show another embodiment of a fabricating process of a double-layered silicide.

In Figure 3A, a silicon dioxide (SiO₂) layer 15 is grown to a thickness of about 1,000Å on a monocrystalline silicon substrate 14 whose specific resistance is roughly 5 ∼ 25Ωcm at 920°C via a thermal oxidation. After that, silane SiH₄ is thermally decomposed at a temperature of 625°C under an atmosphere of about 250mTorr via a LPCVD to thereby deposit a polycrystalline silicon layer 16 to a thickness of about 2,500Å on the upper portion of the silicon dioxide layer 15. Then, phosphorous (P) is implanted into the polycrystalline silicon layer 16 through an ion-implantation method. At this time, ion-implantation energy is approximately 30KeV, and dose quantity is approximately 5 × 10¹⁵ions/cm². In order to prevent damage on the surface of the polycrystalline silicon layer 16 caused by the ion implantation, an etching is performed, using a buffered HF solution obtained by dissolving hydrofluoride (HF) in water in a ratio of 1:100. In Figure 3B, when the etching is finished, tantalum silicide 17 is deposited on the upper portion of the polycrystalline silicon layer 16 to a thickness of about 200∼400Å via a sputtering method, using a composite target composed of tantalum silicide. Then, titanium silicide 18 is deposited thereon to a thickness of about 800∼1,200Å via a sputtering method using a composite target composed of titanium silicide. When completing the deposition of the titanium silicide 18, the resultant structure is subjected to a rapid furnace annealing at 800°C under an argon (Ar) atmosphere for about 20 seconds. This rapid furnace annealing permits a double-layered silicide of an amorphous state to have a crystalline structure shown in Figure 3B.

The melting point of tantalum silicide is 2200°C, i.e. 2,473°K in units of absolute temperature. 0.6 times the absolute temperature is 1483.8°K, and its high-temperature unstability begins occurring at 1210.8°C, which is much higher than 814°C at which the titanium silicide begins to be unstable. The double-layered silicide structure composed of tantalum silicide and titanium silicide can prevent grain growth, plastic deformation and agglomeration which appear in the conventional process, even when performing a subsequent furnace annealing at a high temperature of 900°C or higher.

The high-temperature stability of a double-layered silicide composed of tantalum silicide and titanium silicide according to preferred embodiments of the present invention (e.g. Figures 2b and 3B) was measured and compared with that of titanium silicide of a conventional technique, and the results are shown in Figure 4. The table is obtained after performing furnace annealing of the double-layered silicide of the preferred embodiments of the present invention and the silicide layer of the conventional technique under a nitrogen (N₂) atmosphere for 30 minutes at 850°C, 900°C, 950°C and 1000°C, respectively. As can be understood from Figure 4, in the conventional technique, agglomeration of the titanium silicide begins at 950°C, thereby significantly increasing the sheet resistance. In more detail, the sheet resistance is 2.2Ω/sq at 850°C, but is increased more than twice to 5.3Ω/sq at 950°C. Moreover. the sheet resistance is very high at 2940Ω/sq at 1000°C. However, in the double-layered silicide structure of tantalum and titanium, it can be noted that, in comparisons increase of the sheet resistance is relatively trivial, since the sheet resistance at 1000°C is 5.3Ω/sq as compared with that of 3.8Ω/sq at 850°C.

Although tantalum silicide is used as the lower silicide layer in one embodiment of the present invention, in another embodiment of the present invention, molybdenum silicide, tungsten silicide and the like may be used as the lower silicide layer having a higher melting point than that of the titanium silicide used as the upper silicide layer.

The melting points of tungsten silicide and molybdenum silicide are 2165°C and 1980°C, respectively, which are respectively 2438°K and 2253°K in units of absolute temperature. 0.6 times the absolute temperatures are respectively 1462.8°K and 1351.8°K. Therefore, the high-temperature unstability begins occurring at 1189.8°C for tungsten silicide and at 1078.8°C for molybdenum silicide.

These temperatures are much higher than 814°C at which the titanium silicide begins to be unstable due to temperature. Therefore, agglomeration can be prevented during a subsequent furnace annealing performed at a temperature of 900°C or higher.

Since the above-described semiconductor devices having a double-layered silicide according to embodiments of the present invention greatly improve the high-temperature stability occurring in a subsequent furnace annealing, grain growth, plastic deformation and agglomeration may be largely prevented, thereby remarkably improving the operational characteristics of the semiconductor device.

While particular embodiments of the present invention have been particularly shown and described, it will be understood by those skilled in the art that various changes in form and details may be effected therein without departing from the spirit and scope of the invention as defined by the appended claims.

Embodiments of the invention may usefully be applied to overcoming high-temperature unstability of titanium silicide used for a gate line of a polycide in a DRAM (Dynamic Random Access Memory).

All of the features disclosed in this specification (including any accompanying claims, abstract and drawings), and/or all of the steps of any method or process so disclosed, may be combined in any combination, except combinations where at least some of such features and/or steps are mutually exclusive.

## Claims

1. A method of fabricating a semiconductor device having a double-layered silicide structure, comprising:
forming an oxide layer (8) on a monocrystalline silicon substrate (7);
growing a polycrystalline silicon layer (9) on the oxide layer (8);
forming a first layer (12) of a first metal silicide on the polycrystalline layer (9) and a second layer (13) of a second metal silicide on the first layer (12), the second metal silicide having a melting point which is lower than that of the first metal silicide, by depositing a first layer of the first metal on said polycrystalline silicon layer and a second layer of the second metal on said first layer of the first metal and annealing the first and second layers to form respective layers of metal silicide (12, 13).

2. A method according to claim 1 in which the deposited thickness of the first layer of the first metal is 100-200Å (10-20nm).

3. A method according to claim 1 or claim 2 in which the deposited thickness of the second layer of the second metal is 400∼600Å (40-60nm).

4. A method of fabricating a semiconductor device having a double-layered silicide structure, comprising:
forming an oxide layer (8) on a monocrystalline silicon substrate (7);
growing a polycrystalline silicon layer (9) on the oxide layer (8);
depositing a first layer (12) of a first metal silicide on the polycrystalline layer (9), via a sputtering method using a first composite target;
depositing a second layer (13) of a second metal silicide on the first layer (12), via a sputtering method using a second composite target, the second metal silicide having a melting point which is lower than that of the first metal silicide.

5. A method according to claim 4 in which the deposited thickness of the first silicide layer is 200∼400Å (20-40nm).

6. A method according to claim 4 or claim 5 in which the deposited thickness of the second silicide layer is 800∼1,200Å (80-120nm).

7. A method according to any one of claims 4-6 further comprising annealing the first and second metal silicide layers.

8. A method according to any one of claims 1-3 and 7 in which the annealing takes place at a high temperature in the range 800° to 900°C or greater.

9. A method according to ay preceding claim in which the first metal is tantalum (Ta), molybdenum (Mo) or tungsten (W).

10. A method according to any preceding claim in which the second metal is titanium (Ti).

11. A method according to any preceding claim in which the polycrystalline silicon layer (9) is deposited to a thickness of about 2,500Å (250 nm).

12. A method according to claim 11 in which the polycrystalline silicon layer (9) is deposited by thermally decomposing silane (SiH₄) at a temperature of 625°C under an atmosphere of 250mTorr (33,25 Pa) through low-pressure chemical vapor deposition.

13. A semiconductor device having a double-layered silicide structure, comprising a monocrystalline silicon substrate (7), an oxide layer (8) formed on the substrate (7), a polycrystalline silicon layer (9) formed on the oxide layer (8), a first layer (12) of a first metal silicide formed on the polycrystalline layer (9) and a second layer (13) of a second metal silicide formed on the first layer (12), the second metal silicide having a melting point which is lower than that of the first metal silicide.

14. A device according to claim 13 in which the first metal is tantalum (Ta), molybdenum (Mo) or tungsten (W).

15. A device according to claim 13 or claim 14 in which the second metal is titanium (Ti).

## Patentansprüche

1. Verfahren zum Herstellen einer Halbleitervorrichtung mit einer zweischichtigen Silizidstruktur, das umfaßt:
Ausbilden einer Oxidschicht (8) auf einem Einkristall-Siliziumsubstrat (7);
Aufwachsen einer Vielkristall-Siliziumschicht (9) auf die Oxidschicht (8);
Ausbilden einer ersten Schicht (12) aus einem ersten Metallsilizid auf der Vielkristallschicht (9) und einer zweiten Schicht (13) aus einem zweiten Metallsilizid auf der ersten Schicht (12), wobei das zweite Metallsilizid einen Schmelzpunkt hat, der niedriger ist als der des ersten Metallsilizids, indem eine erste Schicht aus dem ersten Metall auf der Vielkristall-Siliziumschicht und eine zweite Schicht aus dem zweiten Metall auf der ersten Schicht aus dem ersten Metall abgeschieden werden und die erste und die zweite Schicht geglüht werden, um entsprechende Schichten aus Metallsilizid (12, 13) auszubilden.

2. Verfahren nach Anspruch 1, wobei die abgeschiedene Dicke der ersten Schicht aus dem ersten Metall 100-200Å (10-20nm) beträgt.

3. Verfahren nach Anspruch 1 oder 2, wobei die abgeschiedene Dicke der zweiten Schicht aus dem zweiten Metall 400-600Å (40-60nm) beträgt.

4. Verfahren zum Herstellen einer Halbleitervorrichtung mit einer zweischichtigen Silizidstruktur, das umfaßt:
Ausbilden einer Oxidschicht (8) auf einem Einkristall-Siliziumsubstrat (7);
Aufwachsen einer Vielkristall-Siliziumschicht (9) auf die Oxidschicht (8);
Abscheiden einer ersten Schicht (12) aus einem ersten Metallsilizid auf der Vielkristallschicht (9) mit einem Sputterverfahren, bei dem ein erstes zusammengesetztes Target eingesetzt wird;
Abscheiden einer zweiten Schicht (13) aus einem zweiten Metallsilizid auf der ersten Schicht (12) mit einem Sputterverfahren, bei dem ein zweites zusammengesetztes Target eingesetzt wird, wobei das zweite Metallsilizid einen Schmelzpunkt hat, der niedriger ist als der des ersten Metallsilizids.

5. Verfahren nach Anspruch 4, wobei die abgeschiedene Dicke der ersten Silizidschicht 200-400Å (20-40nm) beträgt.

6. Verfahren nach Anspruch 4 oder 5, wobei die abgeschiedene Dicke der zweiten Silizidschicht 800-1200Å (80-120nm) beträgt.

7. Verfahren nach einem der Ansprüche 4-6, das des weiteren das Glühen der ersten und der zweiten Metallsilizidschicht umfaßt.

8. Verfahren nach einem der Ansprüche 1-3 sowie 7, wobei das Glühen bei einer hohen Temperatur im Bereich von 800 bis 900°C oder darüber ausgeführt wird.

9. Verfahren nach einem der vorangehenden Ansprüche, wobei es sich bei dem ersten Metall um Tantal (Ta), Molybdän (Mo) oder Wolfram (W) handelt.

10. Verfahren nach einem der vorangehenden Ansprüche, wobei es sich bei dem zweiten Metall um Titan (Ti) handelt.

11. Verfahren nach einem der vorangehenden Ansprüche, wobei die Vielkristall-Siliziumschicht (9) in einer Dicke von ungefähr 2500Å (250nm) abgeschieden wird.

12. Verfahren nach Anspruch 11, wobei die Vielkristall-Siliziumschicht (9) abgeschieden wird, indem Silan (SiH₄) bei einer Temperatur von 625°C in einer Atmosphäre von 250mTorr (33,25 Pa) über chemisches Aufdampfen bei niedrigem Druck zersetzt wird.

13. Halbleitervorrichtung mit einer zweischichtigen Silizidstruktur, die ein Einkristall-Siliziumsubstrat (7), eine auf dem Substrat (7) ausgebildete Oxidschicht (8), eine auf der Oxidschicht (8) ausgebildete Vielkristall-Siliziumschicht (9), eine auf der Vielkristallschicht (9) ausgebildete erste Schicht (12) aus einem ersten Metallsilizid und eine auf der ersten Schicht (12) ausgebildete zweite Schicht (13) aus einem zweiten Metallsilizid umfaßt, wobei das zweite Metallsilizid einen Schmelzpunkt hat, der niedriger ist als der des ersten Metallsilizids.

14. Vorrichtung nach Anspruch 13, wobei es sich bei dem ersten Metall um Tantal (Ta), Molybdän (Mo) oder Wolfram (W) handelt.

15. Vorrichtung nach Anspruch 13 oder 14, wobei es sich bei dem zweiten Metall um Titan (Ti) handelt.

## Revendications

1. Procédé de fabrication d'un dispositif à semi-conducteurs ayant une structure de siliciure à double couche, comprenant
la formation d'une couche d'oxyde (8) sur un substrat en silicium monocristallin (7) ;
la croissance d'une couche de silicium polycristallin (9) sur la couche d'oxyde (8) ;
la formation d'une première couche (12) d'un premier siliciure métallique sur la couche polycristalline (9) et d'une deuxième couche (13) d'un deuxième siliciure métallique sur la première couche (12), le deuxième siliciure métallique ayant un point de fusion qui est inférieur à celui du premier siliciure métallique, en déposant une première couche du premier métal sur ladite couche de silicium polycristallin et une deuxième couche du deuxième métal sur ladite première couche du premier métal et en recuisant les première et deuxième couches de façon à former des couches respectives de siliciure métallique (12, 13).

2. Procédé selon la revendication 1, dans lequel l'épaisseur déposée de la première couche du premier métal est comprise entre 100 et 200 Å (entre 10 et 20 nm).

3. Procédé selon la revendication 1 ou la revendication 2, dans lequel l'épaisseur déposée de la deuxième couche du deuxième métal est comprise entre 400 et 600 Å (entre 40 et 60 nm).

4. Procédé de fabrication d'un dispositif à semi-conducteurs ayant une structure de siliciure à double couche, comprenant
la formation d'une couche d'oxyde (8) sur un substrat en silicium monocristallin (7) ;
la croissance d'une couche en silicium polycristallin (9) sur la couche d'oxyde (8) ;
la déposition d'une première couche (12) d'un premier siliciure métallique sur la couche polycristalline (9), à l'aide d'un procédé de pulvérisation cathodique utilisant une première cible composite ;
la déposition d'une deuxième couche (13) d'un deuxième siliciure métallique sur la première couche (12), à l'aide d'un procédé de pulvérisation cathodique utilisant une deuxième cible composite, le deuxième siliciure métallique ayant un point de fusion qui est inférieur à celui du premier siliciure métallique.

5. Procédé selon la revendication 4, dans lequel l'épaisseur déposée de la première couche de siliciure est comprise entre 200 et 400 Å (entre 20 et 40 nm).

6. Procédé selon la revendication 4 ou la revendication 5, dans lequel l'épaisseur déposée de la deuxième couche de siliciure est comprise entre 800 et 1200 Å (entre 80 et 120 nm).

7. Procédé selon l'une quelconque des revendications 4 à 6, comprenant de plus le recuit des première et deuxième couches de siliciure métallique.

8. Procédé selon l'une quelconque des revendications 1 à 3 et 7, dans lequel le recuit se fait à une température élevée, située dans la plage comprise entre 800° et 900°C ou plus.

9. Procédé selon l'une quelconque des revendications précédentes, dans lequel le premier métal est du tantale (Ta), du molybdène (Mo) ou du tungstène (W).

10. Procédé selon l'une quelconque des revendications précédentes, dans lequel le deuxième métal est du titane (Ti).

11. Procédé selon l'une quelconque des revendications précédentes, dans lequel la couche de silicium polycristallin (9) est déposée en une épaisseur d'environ 2500 Å (250 nm).

12. Procédé selon la revendication 11, dans lequel la couche de silicium polycristallin (9) est déposée en décomposant thermiquement du silane (SiH₄) à une température de 650°C sous une atmosphère de 250 mTorr (33,25 Pa) à l'aide d'une déposition de vapeur par procédé chimique à basse pression.

13. Dispositif à semi-conducteurs ayant une structure de siliciure à double couche, comprenant un substrat en silicium monocristallin (7), une couche d'oxyde (8) formée sur le substrat (7), une couche de silicium polycristallin (9) formée sur la couche d'oxyde (8), une première couche (12) d'un premier siliciure métallique formée sur la couche polycristalline (9) et une deuxième couche (13) d'un deuxième siliciure métallique formée sur la première couche (12), le deuxième siliciure métallique ayant un point de fusion qui est inférieur à celui du premier siliciure métallique.

14. Dispositif selon la revendication 13, dans lequel le premier métal est du tantale (Ta), du molybdène (Mo) ou du tungstène (W).

15. Dispositif selon la revendication 13 ou la revendication 14, dans lequel le deuxième métal est du titane (Ti).
